# EUROPEAN PATENT APPLICATION

(11) **EP 1 109 258 A2**
(43) Date of publication of application: **20.06.2001**
(21) Application number: 00127675.7
(22) Date of filing: 18.12.2000
(51) Int. Cl.: H01R 12/18, H01R 12/28

(54) **Flexible wiring board and wiring board connecting structure**

(30) Priority: 16.12.1999 JP 35693399
(71) Applicant: SMK Corporation, Tokyo 142 (JP)
(72) Inventor: Asai, Kiyoshi, c/o SMK Corporation, Tokyo (JP); Osawa, Fumio, c/o SMK Corporation, Tokyo (JP)
(74) Representative: Shelley, Mark Raymond

(57) **Abstract**

A flexible wiring board (1) and flexible wiring board connector (2). The flexible wiring board is constructed with land patterns (12a1, 12a2) arrayed along the width of the flexible wiring board so that the pitch between the lead patterns (12bl, 12b2) may be substantially reduced to about one-half compared to a conventional flexible wiring board. The flexible wiring board uses lead patterns, formed both on a front-face side and a rear-face side of a base film (11), to connect contact portions formed on a front-face side. The pitch of the lead patterns, now divided on the front and rear sides of the film, is narrowed without mutual restriction upon the arrangement of the respective lead patterns. Lead patterns from the rear-face side are passed through the film base to form contact portions on a front-face side of the flexible wiring board. Connectors formed to receive the flexible wiring board with narrow pitch were developed.

## Description

The present invention relates to a flexible wiring board to be used in electronic combination with a pair of flexible wiring board connectors. A flexible wiring board provides an electronic conductor with narrow pitch between lead patterns. A flexible wiring board connector provides a secure contacting interface. The invention particularly concerns an electrical conductor and connector that provide substantially uniform contact pressure, improved manufacturing control, and narrow pitch patterns in minimized space.

A flexible wiring board (hereinafter called FPC) having an elongated band shape is used to electrically connect a pair of multipolar connectors. The multipolar connectors are mounted to printed wiring boards and to corresponding circuit patterns upon the printed wiring boards. As a result, individual circuit patterns are electrically connected within an electric device.

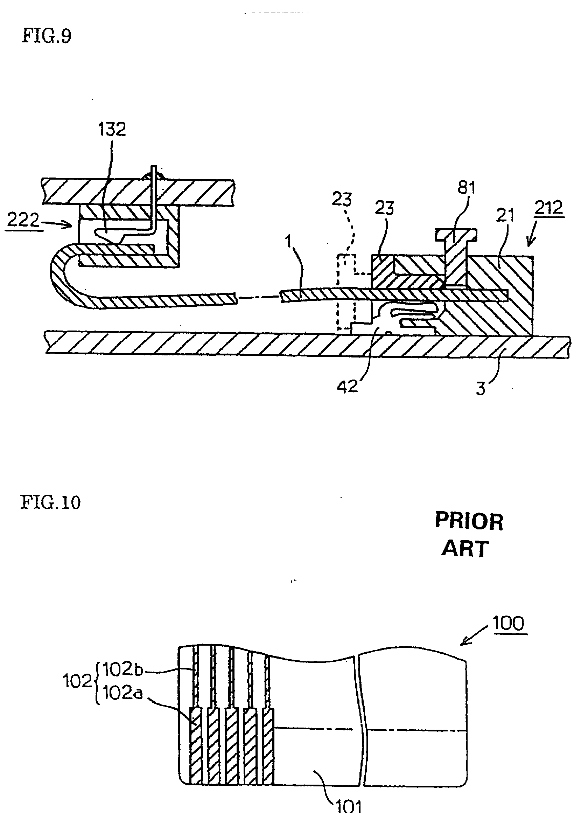

As shown in Figure 10, a conventional FPC 100 contains a plurality of lead patterns 102, printed on the face of a flexible insulating film base 101. Insulating film base 101 is conventionally constructed of PET (polyethylene terephthalate). The plurality of lead
patterns 102 is arranged at predetermined intervals along a width direction of film base 101. The predetermined intervals are calculated to ensure that lead patterns 102 are far enough to be electrically insulated from each other. Each lead pattern 102 is extended and formed along a longitudinal direction of film base 101. Each lead pattern 102 is constructed with a land portion 102a and a lead pattern main body portion 102b. An unillustrated resist formed on lead pattern 102 excludes land portion 102a.

In operation, FPC 100 is inserted into a flexible wiring board connector (hereinafter called a FPC connector). The FPC connector is fastened to a printed wiring board and, as required, is electrically connected to an unillustrated circuit pattern.

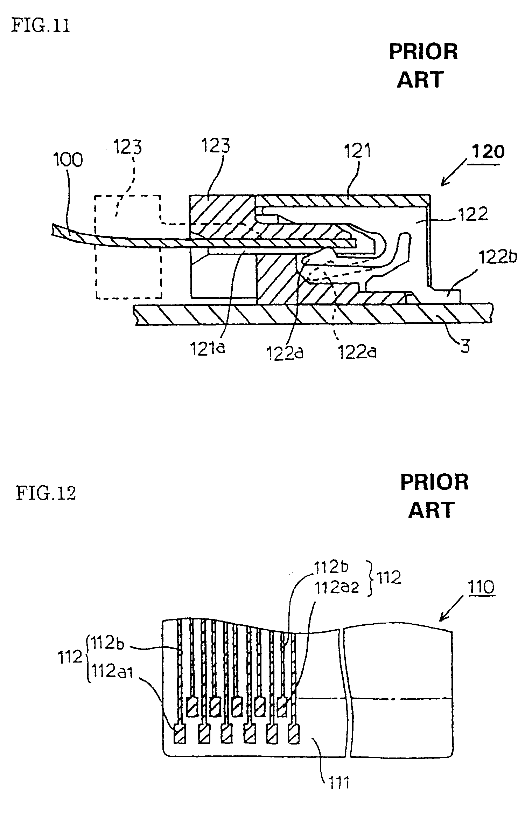

Referring now also to Figure 11, a FPC connector 120 has an insulating housing 121 mounted onto a printed wiring board 3. A contact 122 is fixedly positioned within insulating housing 121. An insulating cover 123 is detachably attached to insulating housing 121.

Contacts 122, in insulating housing 121, are formed by punching a conductive metallic plate. Each contact 122 has an integrally formed female contact portion 122a which contacts land portion 102a on FPC 100, and a leg portion 122b. Based upon electrical needs, leg portion 122b may extend through printed wiring board 3 for connective soldering to an unillustrated circuit pattern on the face of wiring board 3. In the absence of outside electrical need, leg portion 122b may not extend through printed wiring board 3 and does not connect to an unillustrated circuit pattern.

A plurality of contacts 122, in insulating housing 121, are positioned in conformity with the pitch of lead patterns 102 of FPC 100. Contacts 122, supported within insulating housing 121, are elastically deformed in a direction perpendicular to an inserting direction to engage with lead patterns 102. During insertion, a contact face of female contact portion 122a elastically contacts land portion 102a of FPC 100.

The tip face side of FPC 100 is inserted into insulating housing 121 at an insertion port 121a. When inserted, insulating cover 123 is mounted into insulating housing 121.
During insertion, sufficient clearance exists to insert FPC 100 between a ceiling face within insulating housing 121 and female contact portion 122 to permit insertion of FPC 100 tip end into insulating housing 121 without receiving undue contact pressure from female contact portion 122a.

Upon installing insulating cover 123 into insulating housing 121, female contact portion 122a is once elastically deformed, as shown by a broken line in Figure 11.
Thereafter, female contact portion 122a elastically contacts FPC 100. Thus, each land portion 102a of FPC 100 and its respective circuit pattern of printed wiring board 3 are electrically connected to each other through a plurality of female contact portions 122a.

Lead pattern 102, printed on FPC 100, is constructed with multiple poles. For example, 20 poles (20-pole arrangement) or 30 poles (30-pole arrangement), etc.
When lead pattern 102 is increased, the width of connector 120, having the same number of contacts 122 as the lead pattern 102, is correspondingly increased.
Accordingly, when insulating cover 123 is mounted and multiple contacts 122 are simultaneously pressed toward FPC 100, insulating housing 121 receives large pressing forces. Therefore, when the width of connector 102 is increased, the center of insulating housing 121 rises so that sufficient contact pressure in the central portion is difficult to obtain for contacts 122.

Further, when insulating housing 121 is molded, and the width of the connector 120 is increased, warp and dispersion are caused in a width direction. Therefore, uniform contact pressure is difficult to maintain, and hence electrical connection is similarly degraded.

Additionally, when the width of connector 120 is increased, the mounting area of printed wiring board 3 is also increased, thereby creating design inconvenience.

Therefore, in conventional FPC 100, it is desirable that lead patterns 102 have a narrow pitch. In FPC 100, conventional lead patterns 102 are simply arranged in parallel with each other, and a minimum pitch of approximately 0.5 mm is a physical limit. The minimum pitch is the minimum distance between land portions before electrical cross-conduction occurs.

As shown in Figure 12, the land portions 112a1, 112a2 of plural lead pattern 112, are formed on a film base 111, arranged in two zigzag lines. However, this arrangement requires that lead patterns main body 112b, extending from a land portions 112a1, are electrically insulated from land portions 112a2. Through such an arrangement the pitch between the land patterns can be substantially narrowed to about 0.3 mm.
Accordingly, there is a lower size limit for pitch of about 0.3 mm.

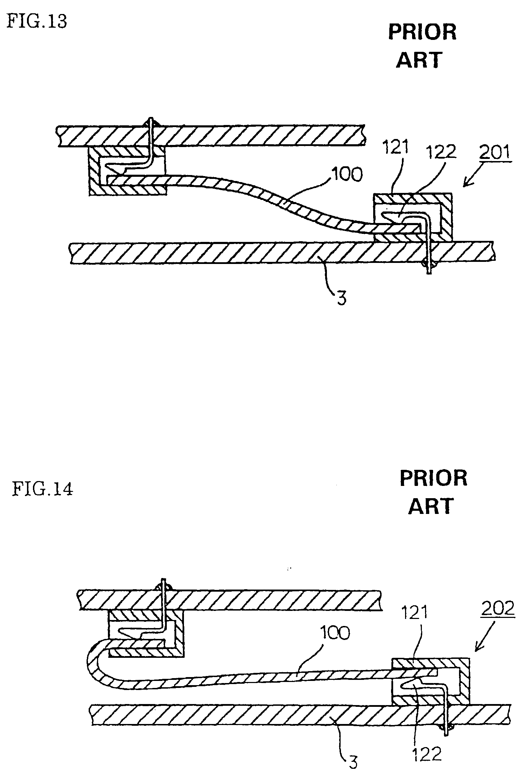

As shown in Figures. 13 and 14, a connector 201 and an inverse connector 202 are adapted to receive conventional FPC lead patterns. Conventional FPC lead patterns are formed on only one face side of a film bases. Connector 201 and inverse connector 202 are schematically shown with corresponding insulating covers 123 omitted. Multiple printed wiring board 3 configurations may require the use of either connector 201 or inverse connector 202 or both. Thus, depending upon printed wiring board 3 design, two kinds of FPC connectors are required.

Briefly stated, the present invention provides a flexible wiring board used in mutual electric connection with a pair of flexible wiring board connectors. The flexible wiring board design provides a narrow pitch between lead patterns. The flexible wiring board connectors provides a secure contacting interface. The result is an electrical conductor and connector set providing sufficient contact pressure, manufacturing control, and narrow pitch patterns in minimum space and structure.

According to an aspect of the invention, there is provided a wiring board comprising: an insulating base, a plurality of lead patterns, arrayed along the insulating base, each of the lead pattern containing a contact portion and a main body portion electrically connected to the contact portion, the plurality of main body portions arrayed along a front portion and a rear portion of the insulating base, the plurality of contact portions arranged on a front tip portion of the insulating base, each main body portion arrayed along the front portion is electrically connected to each corresponding front tip contact portion through a path on the insulating base, and each main body portion arrayed along the rear portion electrically connected to each corresponding front tip contact portion through a path defined in said insulating base.

According to another aspect of the invention there is provided a flexible wiring board connector comprising: an insulating housing containing a plurality of electrically conductive contacts for elastically contacting flexible wiring board land patterns, the contacts having a female contact portion and a leg contact portion and constructed from electrically conducting material, the contacts positioned along two rows in a longitudinal direction of the insulating housing, the female contact portions are elastically deformable in a direction perpendicular to an insertion motion, an insulating cover detachably attached to the insulating housing, the insulating cover elastically directing said female contact portions in a direction orthogonal to the insertion motion, and the female contact portions electrically connecting the flexible wiring board land patterns to the contacts.

According to another aspect of the invention there is provided a flexible wiring board connector comprising: an insulating housing containing a plurality of electrically conductive contacts for contacting flexible wiring board land patterns inserted in an insertion channel, the contacts each having a female contact portion and a leg contact portion and constructed from electrically conducting material, the contacts positioned along one row in a longitudinal direction of said insulating housing, the female contact portions elastically deformable in a direction perpendicular to an insertion motion, an insulating cover detachably attached to the insulating housing, the insulating cover elastically pressing the female contact portions in a direction orthogonal to the insertion motion, the female contact portions electrically connecting the flexible wiring board land patterns to the contacts, a stopper screw with a tip portion rotatively included in the insulating housing; and the stopper screw with a tip rotatively adaptable to block access to the insertion channel by the flexible wiring board.

Various embodiments of the invention will now be more particularly described, by way of example, with reference to the accompanying drawings, in which:
Figure 1 is a partial plan view showing a flexible wiring board according to an embodiment of the present invention.
Figure 2 is a sectional view, taken along line A-A of Figure 1 showing a flexible wiring board according to an embodiment of the present invention.
Figure 3 is a cross-sectional view showing a flexible wiring board connector mounting according to an embodiment of the present invention.
Figure 4 is a partially cut plan view showing the construction of the flexible wiring board connector as seen in Figure 3.
Figure 5 is a front view showing flexible wiring board connector as seen in Figure 3.
Figure 6 is a cross-sectional view showing a pair of connectors connected using a common flexible wiring board connector.
Figure 7 is a cross-sectional view showing another pair of connectors connected using a common flexible wiring board connector.
Figure 8 is a cross-sectional view showing a further pair of connectors connected using a common flexible wiring connector.
Figure 9 is a cross-sectional view showing a pair of connectors connected using a common flexible wiring connector as in Figure 8.
Figure 10 is a partially omitted plan view showing a conventional flexible wiring board.
Figure 11 is a cross-sectional view of a connector showing a flexible wiring board connection using the conventional flexible wiring board in Figure 10.
Figure 12 is a partial omitted plan view showing a conventional flexible wiring board having a narrower pitch.
Figure 13 is a cross-sectional view showing a pair of connectors connected using a conventional flexible wiring board, as shown in Figure 10.
Figure 14 is a cross-sectional view showing another pair of connectors connected using a conventional flexible wiring board, as shown in Figure 10.

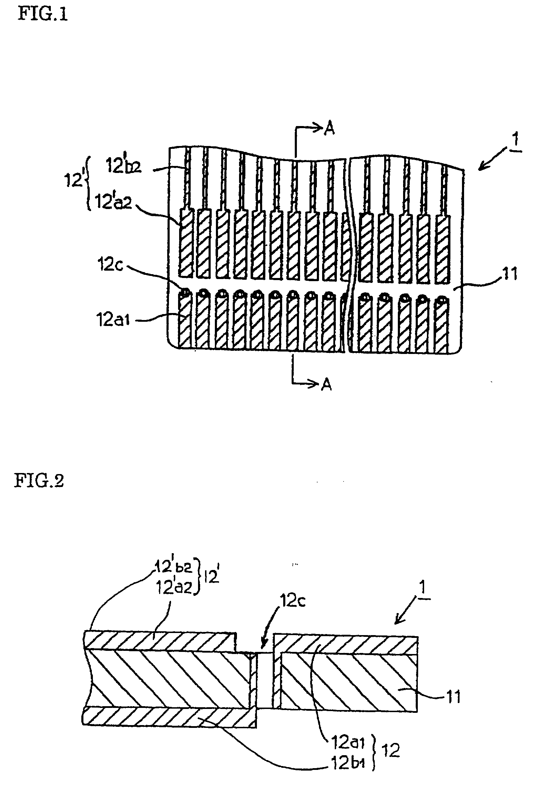

Referring to Figures. 1 and 2, an insulating film base 11 of, for example, PET (polyethylene terephthalate), having at least a tip and a plurality of lead patterns 12 printed on a face, forms a flexible wiring board 1 (hereinafter FPC 1). Lead patterns 12 are arranged at predetermined intervals along the width direction of film base 11.
Lead patterns 12 extend backward (upward in Figure 1) along a longitudinal direction of film base 11.

Lead patterns 12, 12' are arrayed on a front side and a rear side of film base 11. Front side lead patterns 12 each contain a front-side land portion 12al and a front-side lead pattern main body 12b1. Rear side lead patterns 12¹ each contain a rear-side land portion 12¹a2 and a rear-side lead pattern main body 12¹b2. Each land portion 12a1, 12¹a2 is in one of two electrically separated rows along the width of film base 1. The two rows consist of a plurality of front-side land portions 12a1 and a plurality of rear-side land portions 12¹a2. Front- side land portions 12a1 are arranged along the tip face side of film base 11. The rear-side land portions 12¹a2 are arranged along the rear side of front-side land portions 12a1. An unillustrated resist on lead patterns 12, excludes land portions 12a1, 12¹a2 to permit electrical connection thereto. Lead patterns 12, 12¹ are electrically insulated from each other by spacing lead patterns 12, 12' at predetermined intervals on film base 11.

Each front-side land portion 12a1 is connected to the rear face side of film base 11 through a through hole 12c formed in a rear end portion of front-side land portion 12a1. Each front side land portion 12a1 electrically connects to the corresponding rear-side lead pattern main body 12b1 on the rear face side of film base 11. Each rear-side lead pattern main body 12b1 extends on the rear face side of film base 11. Each rear-side land portion 12¹a2 is electrically connected to a corresponding front-side lead pattern main body 12¹b2 on the front face side of film base 11. Each lead pattern main body 12¹b2 extends on the front face side of film base 11. Lead patterns 12b1, 12¹b2 are arranged respectively on the rear and front sides of film base 11 (in a thickness direction).

As a result, the pitch between land portion 12a1, 12¹a2 respectively may be narrowed without mutual restriction. Lead patterns 12, 12¹ contain substantially twice the number of contacts per unit length in the width direction over conventional FPC 100(shown in Figure 10). The width of lead patterns 12, 12¹ is effectively reduced to about one-half, if the number of lead patterns remains the same.

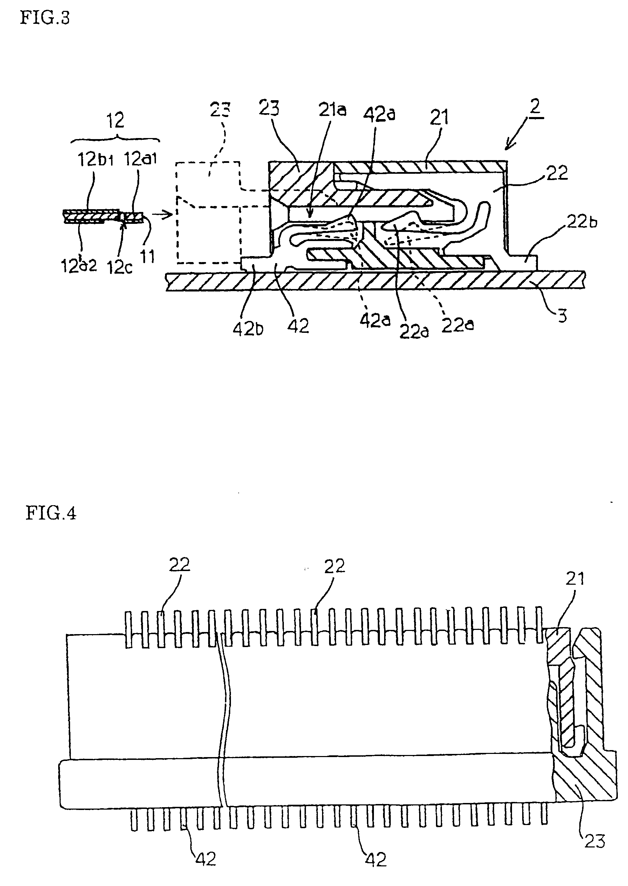

Referring to Figure 3, FPC 1 is inserted into a corresponding FPC connector 2 to electrically connect to an unillustrated circuit pattern through FPC connector 2. FPC connector 2 having an insulating housing 21, is mounted on a printed wiring board 3.
FPC connector 2, contains a plurality of paired contacts 22, 42 fixedly positioned in a symmetrical shape within insulating housing 21. An insulating cover 23 is detachably attached to insulating housing 21.

Contacts 22, 42, are electrically conductive. Contacts 22, 42 have respective female contact portions 22a, 42a, for contacting land portions 12a1, 12a2 in FPC 1, and leg portions 22b, 42b extending to printed wiring board 3. Determined by external conditions, leg portions 22b, 42b may extend through printed wiring board 3 to electrically connect to an unillustrated circuit pattern on printed wiring board 3.

Female contact portions 22a, 42a are fixed into insulating housing 21 elastically deform in a direction perpendicular to a direction of insertion. Female contact portions 22a, 42a each has a contact face that contact FPC 1 during insertion into insulating housing 21. Female contact portions 22a, 42a are separated from FPC 1 by elastic deformation during installation.

To connect FPC 1 and FPC connector 2, FPC 1 is inserted into insertion housing 21 through insertion port 21a. During insertion, the tip face side of FPC 1 first enters insulating housing 21. Insulating cover 23 is then mounted into insulating housing 21. During insertion, sufficient clearance exists to insert FPC 1 between a ceiling face within insulating housing 21 and female contact portions 22a, 42a. This permits FPC 1 to be inserted without receiving excessive contact pressure.

When insulating cover 23 is mounted into insulating housing 21, female contact portions 22a, 42a are elastically deformed once in a direction orthogonal to the insertion motion. This elastic deformation is shown as a broken line in Figure 3.
After insertion, female contact portions 22a, 42a are in elastic contact with FPC 1.
Thus, when required by outside conditions, respective land portions 12a1, 12a2 of FPC 1 and the circuit pattern of printed wiring board 3 are electrically connected through female contact portions 22a, 42a and contacts 22, 42.

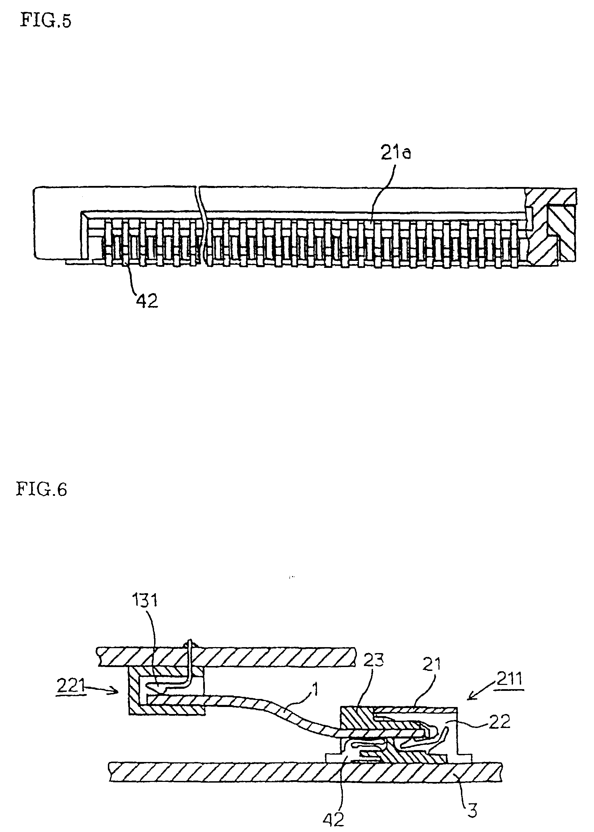

As shown in Figures. 4 and 5, FPC connector 2 contains a plurality of contacts 22, 42 along the width direction of film base 11. Contacts 22, 42, of the same number as lead patterns 12, are attached in two lines at an equal interval along longitudinal direction of the insertion tip. In the present embodiment, both FPC connector 2 and FPC 1 are of multipolar construction where 20 poles (20-pole arrangement) or more are arranged in lead patterns 12.

In comparison with the conventional FPC shown in Figure 10, the width required to connect a similar number of lead patterns 12 is reduced to about 1/2 where the number of lead patterns is the same. Accordingly, the width of FPC connector 2 is also reduced to about one-half where the number of contacts is the same. Further, the size of connector 2 and the mounting area of printed wiring board 3 are also reduced.
Since FPC connector 2 is reduced in size, problems relating to warped connector structure, non-uniform contact pressure, and FPC connector placement area are correspondingly reduced. Alternatively, where a conventional width FPC is used, construction according to FPC 1 would allow use of twice as many lead patterns 12.

As shown in Figure 6 a FPC connector 211, has the same construction as FPC connector 2 in Figure 3. FPC connector 211, with contact 22, and a common FPC connector 221 with a contact 131, are connected to each other through lead pattern 12 and front-side land portion 12a1 of FPC 1.

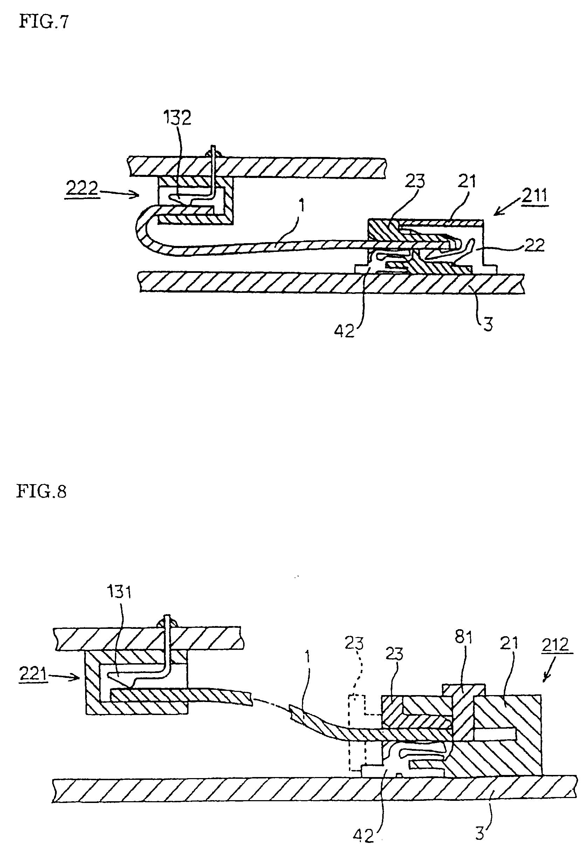

As additionally shown in Figure 7, FPC connector 211, has the same construction as FPC connector 2 in Figure 3. FPC connector 211 with contact 42 and a common FPC connector 222 with a contact 132 are connected to each other through lead pattern 12 and rear-side land portion 12a2 of FPC 1. FPC connector 211 with contact 42 and common FPC connector 221 with connector 132 are connected in an inverted state. Thus, common FPC connectors 221, 222 may be connected using only one FPC connector 211 even where one of the front-side or rear-side land portions of FPC 1 is used as a connecting conductor.

As shown in Figures. 8 and 9, a FPC connector 212 has insulating housing 21 and is mounted onto printed wiring board 3. Contact 42 is fixedly positioned within insulating housing 21. Insulating cover 23 is detachably attached to insulating housing 21, and a stopper screw 81 is rotatively included for switching mounting positions of the FPC connector 212. Stopper screw 81 has a tip portion that is freely advanced and retreated in a FPC insertion path within insulating housing 21. Contact 42 is the only contact in FPC connector 212. Accordingly, the number of parts in FPC connector 212 is reduced and insulating housing 21 may be made compact.

In Figure 8, stopper screw 81 and tip portion are advanced to an intermediate position of the FPC insertion passage within insulating housing 21. FPC 1 of the present invention is positioned in an intermediate position as shown. Here, contact 42 contacts front-side land portion 12a1 of FPC 1. Accordingly, connector 212 with contact 42 and common FPC connector 221 with contact 131 are electrically connected to each other through lead pattern 12 and front-side land portion 12a1.

In Figure 9, stopper screw 81 and tip portion are raised from the intermediate position of the FPC insertion passage within the insulating housing 21. FPC 1 of the present invention is positioned in a complete position as shown. Here, contact 42 contacts rear-side land portion 12a2 of FPC 1. Accordingly, connector 212 with contact 42 and common FPC connector 222 with contact 132 are electrically connected to each other through lead pattern 12 and rear-side land portion 12a2.

Electrical connection with FPC connector 211 may be performed through either front-side land portion 12a1 or rear-side land portion 12a2. Thus, when FPC connector 211 is used to communicate with FPC connector 212, electrical connection may occur even where FPC connector 212 is adapted for front or rear side connection.

In the above embodiment modes, front-side land portion 12a1 and rear-side land portion 12a2 are respectively formed in row positions shifted in forward and backward directions from film base 11 tip. However, the front-side land portion row and the rear-side land portion row may be also arranged in a zigzag shape, or another shape still allowing for electrical insulation between the respective land portions.

In the above embodiment modes for FPC connector 212, film base 11 contains a plurality of front-side land portions 12a1 and a plurality of rear-side land portions 12a2. Therefore, the pitch between a plurality of lead patterns 12 may be reduced to approximately one-half on both the front and rear sides in relation to the conventional case shown in Figure 10. Since FPC connector 212 allows the use of FPC 1, FPC connector 212 helps to limit problems relating to warped connector structures, non-uniform contact pressures, and FPC connector placement area.

Having described preferred embodiments of the invention with reference to the accompanying drawings, it is to be understood that the invention is not limited to those precise embodiments, and that various changes and modifications may be effected therein by one skilled in the art without departing from the scope or spirit of the invention as defined in the appended claims.

## Claims

**1.** A circuit board comprising:-
an insulating base (11),
a first set of contacts (121a2) and a respective first set of lead connections (121b2), each of the said first lead connections being electrically connected to a respective first contact on a first side of the said base;
a second set of contacts (12a1) and a respective second set of lead connections (12b1), each of the said second lead connections being electrically connected to a respective second contact;
characterised in that, said second contacts are disposed on a first side of the said base and said second lead connections are disposed on a second side of the said base.

**2.** A circuit board as claimed in claim 1 wherein said first and second sets of contacts are disposed in respective first and second contact rows positioned towards an edge of the board.

**3.** A circuit board as claimed in claim 2 wherein the said second row is positioned between the said first row and the said edge of the board.

**4.** A circuit board as claimed in claim 2 or claim 3 wherein said second contacts are position along the said edge.

**5.** A circuit board according to any one of claims 2 to 4 wherein said board is elongate and the said first and second contacts are disposed in respective first and second longitudinally spaced rows extending in a direction orthogonal to the longitudinal direction of the board

**5.** A circuit board as claimed in any preceding claim wherein the pitch spacing between adjacent first contacts and between adjacent second contacts is less than or equal to 0.3 mm.

**6.** A circuit board as claimed in any preceding claim wherein respective first and second contacts are offset with respect to one another, whereby to provide a zigzag pattern of respective first and second contacts on said first side of the board.

**7.** A circuit board as claimed in any preceding claim further comprising a plurality of connection apertures (12c) in the said base, and wherein each respective second lead connection is electrically connected to a respective second contact through a respective said aperture.

**8.** A circuit board as claimed in any preceding claim wherein said insulating base is flexible.

**9.** A circuit board as claimed in any preceding claim wherein at least one of said first set of contacts and said second set of contacts contains a single contact.

**10.** A connector for connecting electronic components, said connector comprising:-
a plurality of conductors (22,42) disposed within a connector housing (21), each conductor having a first contact means (22a,42a) for connecting to a first terminal means (12) associated with a first electronic component and a second contact means (22b, 42b) for connecting to a second terminal means associated with a second electronic component,
a terminal receiving recess (21a) in said housing for receiving the said first terminal means, and
an insert (23) for insertion through said terminal receiving recess for urging the said first contact means of at least one conductor and the said first terminal means together to form at least one electrical connection;
characterised in that, said conductors are disposed in rows spaced apart in the connector in the direction of insertion of the said first terminal means in the connector

**11.** A connector as claimed in claim 10 wherein the said conductor rows extend along the connector in a direction orthogonal to the said direction of insertion of the said first terminal means.

**12.** A connector as claimed in claim 10 or claim 11 wherein the said first contact means comprises a resilient member

**13.** A connector as claimed in claim 12 wherein said resilient member is generally u-shaped.

**14.** A connector as claimed in any one of claims 10 to 13 further comprising a stop member (81) for preventing insertion of said first terminal means in the connector beyond a pre-determined position in said recess.

**15.** A connector as claimed in claim 14 wherein said stop member comprises a screw member rotatably mounted in said housing for movement between a first position in which said screw member prevents insertion of said first terminal means beyond the said pre-determined position in said recess and a second position which permits insertion of said first terminal means beyond said pre-determined.

**16.** A connector for connecting electronic components of the type where at least a first electronic component is associated with terminal means (12) having at least two rows of contacts for forming electrical connections with the connector, the said connector comprising:-
a plurality of conductors (22,42) disposed within a connector housing, each conductor having a first contact means (22a, 22b) for connecting to a first terminal means associated with a first electronic component and a second contact means (22b, 42b) for connecting to a second terminal means associated with a second electronic component,
a terminal receiving recess (21a) in said housing for receiving the said first terminal means, and
an insert (23) for insertion through said terminal receiving recess for urging the said first contact means of at least one conductor and the said first terminal means (81) together to form at least one electrical connection;
characterised in that said connector further comprises selection means for selecting a row of contacts on said first terminal means for contact with said respective first contacts when the said first terminal in inserted in the said recess.

**17.** A connector as claimed in claims 16 wherein said selection means comprises a stop member for preventing insertion of said first terminal means in the connector beyond a pre-determined position in said recess.

**18.** A connector as claimed in claim 17 wherein said stop member comprises a screw member rotatably mounted in said housing for movement between a first position in which said screw member prevents insertion of said first terminal means beyond the said pre-determined position in said recess in which said first contact means contact a first row of contacts on said first terminal means, and a second position which permits insertion of said first terminal means beyond said pre-determined position to a position where said first contact means contact a second row of contacts on said first terminal means.
